# EUROPÄISCHE PATENTANMELDUNG

(11) **EP 1 968 369 A2**
(43) Veröffentlichungstag der Anmeldung: **10.09.2008**
(21) Anmeldenummer: 08101648.7
(22) Anmeldetag: 15.02.2008
(51) Int. Cl.: H05K 5/02

(54) **Drucker mit USB-Anschluss**

(30) Priorität: 09.03.2007 DE 202007003572 U
(71) Anmelder: Wincor Nixdorf International GmbH, 33106 Paderborn (DE)
(72) Erfinder: Schulte, Heinz, 33106, Paderborn (DE); Niggemeyer, Susanne, 33098, Paderborn (DE); Wiesbrock, Wilfried, 33397, Rietberg (DE)
(74) Vertreter: Schaumburg, Thoenes, Thurn, Landskron

(57) **Zusammenfassung**

Bei einem Drucker mit einem Gehäuse (10) und einer Druckersteuerung (12) mit mindestens einer USB-Buchse (14) zum Anschluss eines USB-Kabels (16, 18) sind an dem Gehäuse (10) Haltemittel (20, 22) zum Festlegen des USB-Kabels (18) ausgebildet.

## Beschreibung

Die Erfindung betrifft einen Drucker mit einem Gehäuse und einer Druckersteuerung mit mindestens einer USB-Buchse zum Anschluss eines USB-Kabels.

Drucker der vorstehend genannten Art werden häufig in größere Geräte wie beispielsweise einen Geldautomaten oder in Möbel von Bank- oder Postschaltern eingebaut. In Abhängigkeit von der Einbausituation des Druckers kann es dabei passieren, dass unbeabsichtigt der USB-Stecker an dem USB-Kabel aus dem Anschluss des Druckers gezogen wird. Dies kann sehr lästig sein, insbesondere dann, wenn der USB-Anschluss an dem eingebauten Drucker schwer zugänglich ist.

Der Erfindung liegt die Aufgabe zugrunde, hier Abhilfe zu schaffen.

Zur Lösung dieser Aufgabe wird erfindungsgemäß vorgeschlagen, dass an dem Gehäuse Haltemittel zum Festlegen des USB-Kabels ausgebildet sind. Dadurch wird eine Zugentlastung an dem USB-Kabel geschaffen, die verhindert, dass der Stecker an dem USB-Kabel durch Zug an dem Kabel aus der USB-Buchse herausgezogen wird.

Vorzugsweise haben die Haltemittel mindestens ein Klemmelement zum Einklemmen des USB-Kabels. Ferner weisen bei einer bevorzugten Ausführungsform die Haltemittel mindestens ein zwischen dem Klemmelement und der USB-Buchse angeordnetes Umlenkelement zur Bildung einer Kabelschikane auf. Aufgrund der durch das Umlenkelement bzw. die Schikane erzwungenen Krümmung des Kabels wird vermieden, dass das Kabel unter Zug in dem Klemmelement gleitet.

Vorzugsweise sind die Haltemittel einstückig mit dem Gehäuse ausgebildet, so dass keine zusätzlichen Teile benötigt werden, die erst noch montiert werden müssen. Diese Lösung ist besonders vorteilhaft, wenn das Gehäuse beispielsweise aus Kunststoff besteht und die Haltemittel ohne zusätzliche Bearbeitungsschritte beim Herstellen des Gehäuses mit ausgeformt werden können.

Die folgende Beschreibung erläutert in Verbindung mit der beigefügten Zeichnung die Erfindung anhand eines Ausführungsbeispiels. Es zeigen:
- Fig.1: eine schematische Draufsicht auf den Teil eines Druckergehäuses mit den Haltemitteln für das USB-Kabel und
- Fig.2: einen schematischen Schnitt entlang der Linie II-II in Fig.1.

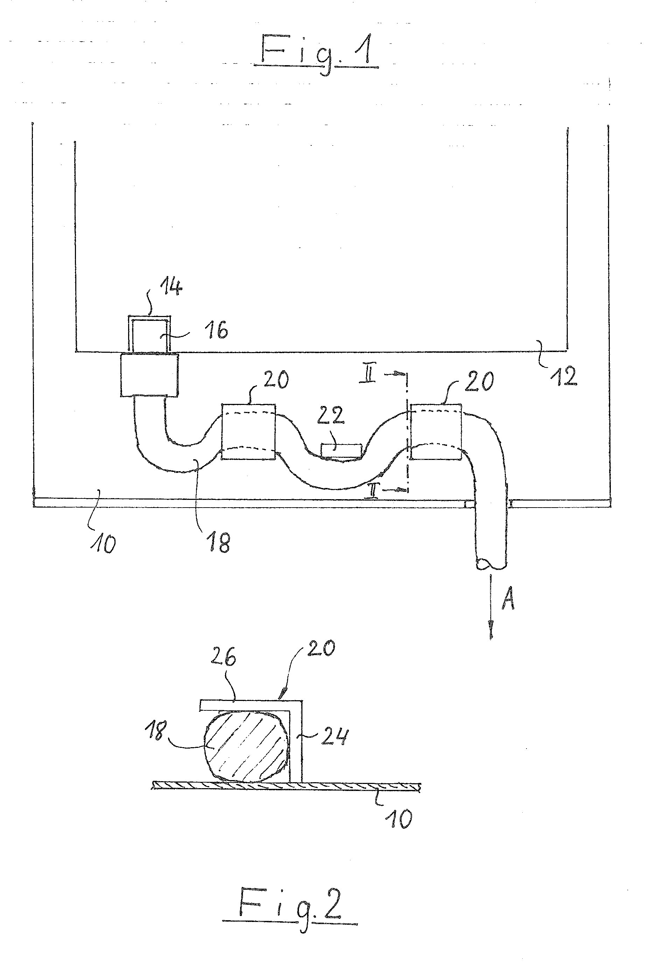

In der Fig.1 ist mit 10 ein Teil eines Druckergehäuses, beispielsweise die Bodenplatte desselben und mit 12 eine Druckersteuerung bezeichnet. Die Druckersteuerung hat eine USB-Buchse 14 zur Aufnahme eines USB-Steckers 16 am Ende eines USB-Kabels 18. Das USB-Kabel 18 ist mit Haltemitteln an dem Gehäuseteil 10 festgelegt. Diese Haltemittel umfassen zwei Klemmelemente 20 und ein zwischen diesen Klemmelementen angeordnetes Umlenkelement 22, die zusammen eine Schikane für das USB-Kabel 18 bilden, welche eine mehrfache Krümmung des USB-Kabels 18 erzwingt.

Die Klemmelemente 20 sind in Form rechtwinkliger Haken ausgebildet mit einem von dem Gehäuseteil 10 abstehenden und senkrecht zu diesem gerichteten Schenkel 24 und einem zu dem Gehäuseteil 10 parallelen Schenkel 26. Der Abstand zwischen dem parallelen Schenkel 26 und der Fläche des Gehäuseteils 10 ist so bemessen, dass das USB-Kabel 18 zwischen dem parallelen Schenkel 26 und dem Gehäuseteil 10 eingeklemmt wird.

Wird das USB-Kabel 18 in der in der Fig.1 dargestellten Weise in die Haltemittel 20, 22 eingelegt, so bilden diese Haltemittel eine Zugentlastung. Wird auf das USB-Kabel 18 in Richtung des Pfeiles A in Fig.1 ein Zug ausgeübt, so verhindern die Haltemittel 20, 22, dass dieser Zug auf den USB-Stecker 16 wirkt und diesen aus der Buchse 14 herauszieht.

## Patentansprüche

1. Drucker mit einem Gehäuse (10) und einer Druckersteuerung (12) mit mindestens einer USB-Buchse (14) zum Anschluss eines USB-Kabels (16, 18), **dadurch gekennzeichnet, dass** an dem Gehäuse (10) Haltemittel (20, 22) zum Festlegen des USB-Kabels (18) ausgebildet sind.

2. Drucker nach Anspruch 1, **dadurch gekennzeichnet, dass** die Haltemittel mindestens ein Klemmelement (20) zum Einklemmen des USB-Kabels (18) haben.

3. Drucker nach Anspruch 2, **dadurch gekennzeichnet, dass** die Haltemittel mindestens ein zwischen dem Klemmelement (20) und der USB-Buchse (14) angeordnetes Umlenkelement (22) zur Bildung einer Kabelschikane haben.

4. Drucker nach einem der Ansprüche 1 bis 3, **dadurch gekennzeichnet, dass** die Haltemittel (20, 22) einstückig mit dem Gehäuse (10) ausgebildet sind.
